# EUROPÄISCHE PATENTANMELDUNG

(11) **EP 1 517 603 A1**
(43) Veröffentlichungstag der Anmeldung: **23.03.2005**
(21) Anmeldenummer: 04021933.9
(22) Anmeldetag: 15.09.2004
(51) Int. Cl.: H05K 7/20, G06F 1/20, H01L 23/427

(54) **Kühlvorrichtung für elektronische und elektrische Bauelemente**

(30) Priorität: 16.09.2003 DE 20314532 U
(71) Anmelder: SGL CARBON AG, 65203 Wiesbaden (DE)
(72) Erfinder: Thiele, Walter, Dr., 53173 Bonn (DE); Pries, Wulf, 44229 Dortmund (DE); Jeuschede, Michael, 58313 Herdecke (DE); Hoffmann, Peter, 58239 Schwerte (DE)

(57) **Zusammenfassung**

Kühlvorrichtung für elektronische und elektrische Bauelemente bestehend aus einem, von einem Kühlmedium durchströmten, geschlossenen Kreislauf mit einem Verdampfer (2), einer Verdampferhaube (3) aus Graphitmaterial, fluidischen Verbindungen (5) und einem Kondensator (4), welche ohne bewegliche Teile auskommt sowie einen effektiven Schutz der elektronischen und elektrischen Bauelemente gegen ein breites Spektrum elektromagnetischer Strahlung bietet.

## Beschreibung

Die vorliegende Erfindung betrifft eine Vorrichtung zur Ableitung von Wärme von der Oberfläche elektronischer und elektrischer Bauelemente wie Computerprozessoren, Laserdioden, Kleinstmotoren oder elektronischen Leistungsbauelementen.

Elektronische Geräte produzieren aus einem Teil der ihnen zugeführten Elektroenergie Verlustwärme, welche zur Verhinderung von Ausfällen der elektronischen Komponenten abgeführt werden muss. Insbesondere für Computer ist es notwendig, die Verlustwärme der Central Processing Unit (CPU) abzuführen.
Nach heutigem Stand der Technik erzeugt eine CPU in einem handelsüblichen Personalcomputer 50 bis 120 Watt Verlustleistung, welche als Wärme abgeführt werden muss. Allerdings ist bei zukünftigen Prozessorgenerationen mit einer Verlustleistung größer als 120 W zu rechnen. Um ein Funktionieren der CPU zu gewährleisten, ist es in Abhängigkeit des Prozessortyps erforderlich, die Temperatur an der CPU auf Temperaturen von maximal rund 60 °C durch Kühlung zu begrenzen. Neben der CPU befinden sich in einem komplexen elektronischen Gerät, wie einem Personalcomputer, weitere Komponenten, deren maximale Arbeitstemperatur ebenfalls nach oben begrenzt ist. Zu diesen gehören Grafikkarten sowie Speicherchipsätze als signifikante Verlustwärmequelle.
Von Seiten vieler Hersteller der elektronischen Bauelemente bestehen Vorgaben, dass die maximale Innenraumtemperatur (Local Ambiente Temperature - LAT) in einem Gehäuse herstellerabhängig maximal 50 °C betragen darf. Weitere Vorgaben für ein Kühlsystem für elektronische Geräte bestehen darin, dass das Gewicht des Kühlsystems limitiert ist und weiterhin sehr hohe Anforderungen an die Stabilität des Systems wegen des Transports der elektronischen Geräte gestellt wird.
Ebenso ist die Geräuschbelastung des Kühlsystems ein wichtiges Kriterium bei dessen Beurteilung.
Allgemein bekannt sind Vorrichtungen zur Kühlung von elektronischen Bauelementen, insbesondere von CPUs, durch Kombinationen von Kühlkörpern und geeigneten Lüftern. Bei bekannten Anordnungen dieser Art sind dafür entweder sehr große Kühlkörper und/oder leistungsstarke Lüfter notwendig. Die letztgenannten führen zu hohen Geräuschpegeln und erzeugen zusätzliche elektromagnetische Felder, die sich störend auf die sensiblen elektronischen Bauteile des Computers auswirken.
Außerdem wächst mit zunehmender Größe der verwendeten Kühlkörper auch deren Eigengewicht zu einem technischen Problem heran, da die Befestigungsstrukturen um das zu kühlende elektronische Bauteil nicht beliebig mechanisch belastbar ist und zum anderen, speziell bei Laptops, das Gesamtgewicht des Computers für den Anwender eine wesentliche Rolle spielt.
Typisch sind Kühlkörper aus Metall, speziell Kupfer oder Aluminium, welche aufgrund Ihre guten Eigenschaften bezüglich der Wärmeaufnahme und ―ableitung eingesetzt werden. Solche Kühlkörper sind oftmals mit Rippen oder anderen, die Oberfläche vergrößernden, Strukturmerkmalen ausgestattet. Jedoch kann aufgrund des Eigengewichts der Metalle die Größe der Kühlkörper, insbesondere für neue Computergenerationen, nicht beliebig gesteigert werden. So besitzt beispielsweise Kupfer eine Dichte von 8,96 g/cm³, während diese bei Aluminium immer noch 2,70 g/cm³ beträgt.

Weiterhin werden für die Kühlung von elektronischen Geräten Heatpipes bzw. Wärmerohre eingesetzt. Diese transportieren Wärme vom zu kühlenden Objekt zu einem räumlich etwas entfernten Kühlkörper. Von dort wird die Wärme ebenfalls mit Hilfe eines Lüfters abgeleitet.
So ist in US 6,288,895 ein Apparat für die Kühlung elektronischer Komponenten in einem Computer offenbart, welches neben einem Lüfter ein Wärmerohr zur Ableitung des Verlustwärmestromes von dem wärmeerzeugenden elektronischen Bauelement nutzt und dessen Kondensator mit einem kanalförmigen Wärmeüberträger in thermischer Verbindung steht, der Wärmeübertragungsrippen aufweist. Nachteilig an diesem Apparat ist, dass das Wärmerohr aufgrund der horizontalen Anordnung einen Zwangsrücklauf für das Kältemittel benötigt und zusätzliche Energie für den Lüfter verbraucht, der obendrein eine unerwünschte Geräuschquelle darstellt.
Neuerdings gibt es auch Wärmerohr-Kühler ohne Lüfter. Nachteil in beiden Fällen ist jedoch, dass die abgeführte Wärme im Gehäuse des Computers verbleibt. Wärmerohr-Kühler erfordern also generell eine sehr gute Durchlüftung des Gehäuses, wodurch eine weitere Geräuschbelastung bedingt ist.
Des weiteren sind Wärmerohr-Kühler nur zulässig, wenn die Computer-Gehäuse gegen hochfrequente (HF) Strahlung abgeschirmt werden. Sind die Wärmerohre mit HF-Strahlungsquellen, wie etwa CPUs, direkt verbunden, agieren sie als Antennen und leiten diese Energie auf das Computergehäuse weiter, welches dann selbst als Antenne wirken kann und die Energie im Resonanzpunkt abstrahlt. Dieser starke Elektrosmog kann bei Benutzern des Computers zu dauerhaften gesundheitlichen Schäden führen. Daher unterliegen vor allem in Europa die Verwendung von Wärmerohr-Kühlern starken Restriktionen.

Die Aufgabe der vorliegenden Erfindung ist es, eine wie oben erwähnte Vorrichtung derart zu gestalten, dass alle zuvor genannten Nachteile überwunden und vor allem die Anforderungen nach einem LAT-Wert im Gehäuse von maximal 50 °C auch für neue Computergenerationen erfüllt werden.
Diese Aufgabe wird erfindungsgemäß dadurch gelöst, dass eine Kühlvorrichtung bereitgestellt wird, die ohne bewegliche Komponenten wie Lüfter oder Pumpen die Abwärme des zu kühlenden Objektes abtransportiert, somit sehr leise und energieeffizient arbeitet, und zusätzlich einen effektiven Schutz gegen elektromagnetische Strahlung bietet.
Erfindungsgemäß besteht die Kühlvorrichtung aus einer, mit dem zu kühlenden Objekt in Verbindung stehenden, Verdampfereinheit, welche wiederum mit einem räumlich entfernten Dampfkondensator verbunden ist von dem ein Kühlmedium durch reine Schwerkraft der Verdampfereinheit zugeführt wird. Dabei geht das Kühlmedium unter Wärmeaufnahme vom flüssigen in den dampfförmigen Aggregatzustand über und wird dem Dampfkondensator wieder zugeführt, an den es die zuvor aufgenommene Verdampfungswärme wieder abgibt und sich dabei verflüssigt, so dass ein geschlossener Kreislauf entsteht. Die erfindungsgemäße Verdampfereinheit besteht aus einem vom Kühlmedium durchströmten Verdampfer und einer Verdampferhaube aus Graphitmaterial, deren wesentlicher Vorteil die starke elektromagnetische Abschirmungs- und Absorptionswirkung des Graphits bildet. Im Vergleich zum Stand der Technik, bei dem durch die Lüfter zusätzliche elektromagnetische Störfelder erzeugt werden, fallen erfindungsgemäß diese Störfelder nicht nur weg, sondern es wird sogar ein zusätzlicher Schutz gegen andere elektromagnetische Störfelder eingebaut.
Die Kühlvorrichtung orientiert sich an der an sich seit langem bekannten Absorptionskühlung. Sie besitzt jedoch keine beweglichen Komponenten wie Motoren oder Pumpen und ist somit verschleißfrei. Daher arbeitet sie nahezu geräuschlos. Bei Verwendung korrosionsfreier und alterungsbeständiger Materialien hat die Vorrichtung eine theoretisch unbegrenzte Lebensdauer.
Weiterhin zeichnet sich die Vorrichtung vor allem dadurch aus, dass sie zu ihrem Betrieb keine zusätzliche, kostenverursachende mechanische, elektrische oder sonstige Energie benötigt. Sie funktioniert allein unter Ausnutzung der Abwärme, die das zu kühlende Objekt selbst produziert. Darüber hinaus arbeitet sie durch Wahl eines geeigneten Kühlmediums bereits im Bereich relativ niedriger Arbeitstemperaturen, so auch bei Zimmertemperatur. Auch sind keine komplexen elektronischen Steuerungen nötig.
Die erfindungsgemäße Vorrichtung ist des weiteren mit einer Verdampfereinheit ausgestattet, die sich durch ein geringes Gewicht auszeichnet. Der Verdampfer, welcher bevorzugt aus einem Material hoher Wärmeleitfähigkeit besteht, hat eine leichte Haube aus Graphit oder graphithaltigem Material. Graphit hat eine Dichte im Bereich von 1,0 g/cm³ bei verpresstem Flockengraphit bis zu 1,9 g/cm³ bei synthetischem Graphit und ist damit wesentlich leichter als Metall.
Die Wärmeleitfähigkeit kann bei synthetischem Graphit über 100 W/mK und bei Flockengraphit in der Graphitschichtebene mehr als 400 W/mK betragen. Dadurch bietet eine aus Graphitmaterialien hergestellte Verdampferhaube noch eine zusätzliche lokale Wärmeableitung.
Der Verdampfer wird gemäß einer besonderen Ausführungsform aus gut Wärme leitenden und hochfesten mit Graphit gefüllten Kunststoffmassen herstellt, wodurch eine zusätzliche Abschirmung gegen elektromagnetische Strahlung geboten wird.
Gemäß einer weiteren Ausführungsform kann auch die Verdampferhaube aus mit Graphit gefülltem Kunststoff oder alternativ aus imprägnierten Graphitfolienstücken, die unter anderem unter dem Markennamen ® SIGRAFLEX vertrieben werde, hergestellt werden.

Die vorliegende Erfindung wird nun im Detail mit Referenz zu den beiliegenden Zeichnungen erläutert. Dabei zeigt Figur 1 eine schematische Darstellung die erfindungsgemäße Vorrichtung zur Ableitung von Wärme von der Oberfläche elektronischer und elektrischer Bauelemente. In Figur 2 ist eine Verdampfereinheit in einer Seitenansicht dargestellt, wie sie im Computer eingebaut vorliegt. Figur 3 zeigt eine perspektivische Querschnittansicht durch eine Verdampfereinheit. Figur 4 ist eine Explosionsdarstellung einer Verdampfereinheit perspektivisch von oben. In Figur 5 wird eine perspektivisch Schnittansicht einer Verdampfereinheit gezeigt, welche im Wesentlichen vollständig aus Graphitwerkstoff hergestellt ist.

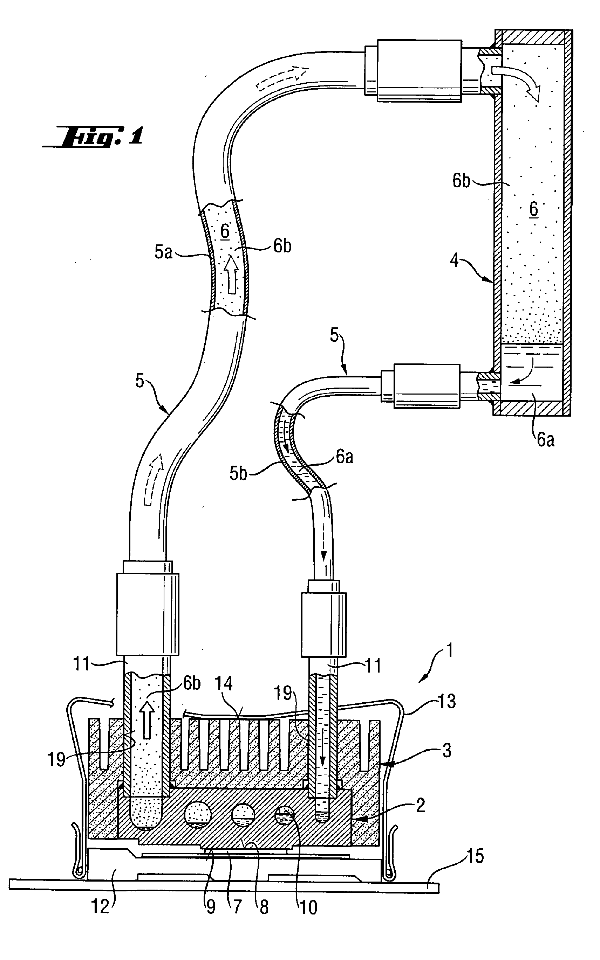

Die erfindungsgemäße Vorrichtung gemäß Fig. 1 besteht aus folgenden Hauptteilen: Verdampfereinheit (1), Dampfkondensator (4), fluidischen Verbindungen (5) sowie einem geeigneten Kühlmedium (6).
Die Verdampfereinheit (1) besteht aus einem Verdampfer (2) aus einem Material mit hoher thermischer Leitfähigkeit und einer Verdampferhaube (3) aus Graphit oder Graphit enthaltendem Material. Als bevorzugtes Material für den Verdampfer (2) werden die Metalle Kupfer oder Aluminium eingesetzt. Gemäß einer besonderen Ausführungsform dieser Erfindung kann aber auch thermoplastischer oder bevorzugt duroplastischer Kunststoff mit einer Füllung von wenigstens 50 Gew% Graphitpulver oder Kokspulver oder Mischungen daraus als Material für den Verdampfer (2) verwendet werden. Aus einem solchen Material lassen sich durch industrielle Verarbeitungsmethoden, wie etwa Spritzguss, komplexe Verdampfergeometrien darstellen.
Der Verdampfer (2) befindet sich im thermischen Kontakt mit dem gekühlten elektronischen Bauteil (7) und nimmt Wärme von diesem auf. Um eine optimale Wärmeübertragung zu gewährleisten, soll die entsprechende Kontaktfläche so groß wie möglich ausgestaltet sein. In der Regel besitzt das gekühlte elektronische Bauteil (7) einen ebenen Adapterfläche (8), auf dem passgerecht der möglichst polierte Adapterfläche (9) des Verdampfers (2) aufsitzt. Dazwischen aufgetragene Wärmeleitpasten, die üblicherweise Silber enthalten, verbessern nicht nur den Wärmeübergang von einem Material zum anderen, sondern sorgen durch ihre elastischen Eigenschaften ggf. auch für einen Ausgleich bei unterschiedlichem thermischen Ausdehnungsverhalten.
Im Innern ist der Verdampfer (2) so ausgestaltet, dass er vom flüssigen Kühlmedium (6a) durchströmt werden kann. Dabei wird auf eine möglichst große Grenzfläche zwischen Verdampfer (2) und durchströmendem Kühlmedium (6) geachtet. Erreicht wird dies unter anderem durch einen mäanderförmigen Durchflusskanal (10) oder durch Oberflächen vergrößernde Elemente im Verdampfer.
Der Verdampfer (2) ist über zwei fluidische Verbindungen (5) so mit dem Dampfkondensator (4) verbunden, dass ein geschlossener Kreislauf entsteht. Diese fluidischen Verbindungen (5) bestehen aus geeigneten handelsüblichen Kühlmittelschläuchen oder ―rohren mit einer Druckdichte von über 30 bar und einem maximalen Außendurchmesser von 40 mm. Sie sind chemisch und physikalisch gegenüber dem Kühlmedium (6) beständig und sind druck- und vakuumdicht.
Wichtig dabei ist, dass die sogenannte Vorlaufverbindung (5a), also die fluidische Verbindung (5) die das Kühlmedium (6) auf dem Weg vom Verdampfer (2) zum Dampfkondensator (4) durchströmt, einen größeren Querschnitt besitzt, als die Rücklaufverbindung (5b), in der das Kühlmedium (6) vom Dampfkondensator (4) zum Verdampfer (2) zurückfließt.
Wie man in Figur 1 deutlich sieht, wird der Verdampfer (2) größtenteils von einer Verdampferhaube (3) ummantelt und steht in flächigem Kontakt mit dieser. Dieser enge Kontakt wird durch die Verwendung von geeigneten technischen Klebstoffen ermöglicht. Die Verdampferhaube (3) aus Graphitmaterial bietet eine hocheffektive Abschirmung sowie gleichzeitig eine Absorption von HF-Strahlung. Somit wird durch die Verdampferhaube (3) aus Graphitmaterial insgesamt Schutz über ein breites elektromagnetisches Frequenzspektrum geboten.
Das Graphitmaterial der Verdampferhaube (3) kann aus synthetischem Graphit, Naturgraphit, Flockengraphit oder Mischungen daraus bestehen, wobei optional noch Additive wie etwa Ruß, Carbonfasern, Carbon Nanotubes und/oder Metall- und
Keramikpartikel zugesetzt sind. Zusätzlich kann zur weiteren Verbesserung der Eigenschaften das Graphitmaterial mit Metallen imprägniert sein. Die Verdampferhaube (3) kann auch aus thermoplastischem oder duroplastischem Kunststoff mit einer Füllung von mehr als 50 Gew% Graphitpulver oder Kokspulver oder Mischungen daraus, optional mit den oben genannten Additiven, hergestellt werden.
Der Dampfkondensator (4) besitzt bevorzugt die Form eines geschlossenen Hohlzylinders, kann aber auch andere geometrische Ausführungsformen besitzen. Er besteht aus einem Material hoher thermischer Leitfähigkeit wie etwa Kupfer und ist bevorzugt durch ein Lochblech oder andere konstruktive Maßnahmen vor direktem Zugriff geschützt.

Das flüssige Kühlmedium (6a) nimmt im Verdampfer (2) Wärme auf und verdampft. Das gasförmige Kühlmedium (6b) gelangt durch den Vorlauf in den Kondensator (4). Im Kondensator (4) gibt das gasförmige Kühlmedium (6b) die zuvor aufgenommene Verdampfungswärme wieder ab und verflüssigt sich dabei. Das verflüssigte Kühlmedium (6a) fließt über den Rücklauf wieder in den Verdampfer (2).
Das Kühlmedium (6) besteht aus einer chemischen Substanz oder einem Gemisch solcher Substanzen mit einem Siedepunkt zwischen -60 °C bis 0 °C. Zur Verwendung kommen vor allem Propan und Butan sowie die Kühlmittel R152a, R134a, R22 oder deren Äquivalente.
Verdampfer (2) und Dampfkondensator (4) besitzen geeignete Anschlussstutzen (11) zum Herstellen der notwendigen fluidischen Verbindungen (5). Die Verbindung zwischen Anschlussstutzen (11) und fluidischen Verbindungen (5) wird durch Bajonettverschlüsse oder ähnliche konstruktive Vorkehrungen gegen eine Lockerung abgesichert.
Bei einer bevorzugten Ausführungsform ist der Dampfkondensator (4) mehrstufig aufgebaut. Er besteht in dieser Form aus zwei oder mehreren nacheinander vom Kühlmedium (6) durchströmten Hohlzylindern, die thermisch weitestgehend voneinander entkoppelt, jedoch fluidisch miteinander verbunden sind. Dies wird durch Verwendung von Schläuchen oder Rohren aus Werkstoffen mit möglichst geringer Wärmeleitfähigkeit erreicht.
Bei einer weiteren bevorzugten Ausführungsform enthält der Dampfkondensator (4) spezielle Einbauten, wie Wärmeableitbleche, welche für eine Optimierung des Kreislaufprozesses sorgen.
Eine weitere Ausführungsform ist versehen mit druck- und vakuumdichten Absperrventilen. Diese sind mechanisch mit dem Dampfkondensator (4) verbunden, trennen ihn von den fluidischen Verbindungen (5) und ermöglichen einen hermetischen Abschluss des Dampfkondensators (4).
Je nach Anwendung wird der Dampfkondensator (4) mehr oder weniger weit räumlich vom zu kühlenden elektronischen Bauteil (7) bzw. der Verdampfereinheit (1) installiert. Die Verdampfereinheit (1) als auch der Dampfkondensator (4) können horizontal, vertikal oder schräg installiert werden, wobei je nach gewünschter Raumrichtung einige Konstruktionsmerkmale modifiziert werden müssen. Die Unterkante des Dampfkondensators (4) muss in jedem Fall oberhalb der Oberkante des Verdampfers (2) liegen. Beim Einsatz für Computer wird der Dampfkondensator (4) bevorzugt außerhalb des Computergehäuses befestigt, wobei man die fluidischen Verbindungen (5) durch geeignete Öffnungen im Computergehäuse durchführt.
Es können auch mehrere Verdampfereinheiten (1) gleichzeitig an einen Kondensator gekoppelt sein. Dies ist zum Beispiel bei Computern der Fall, in denen mehrere Bauelemente gleichzeitig gekühlt werden müssen.

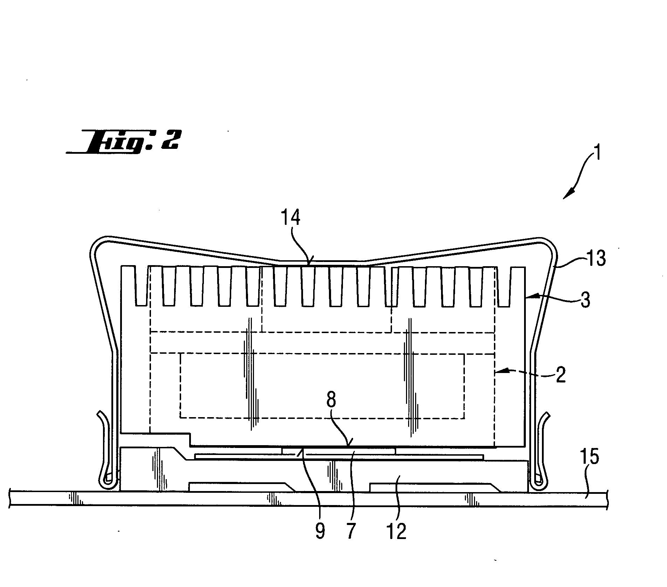

Figur 2 zeigt die Seitenansicht einer im Computer eingebauten Verdampfereinheit (1). Die Verdampferhaube (3) aus Graphit umhüllt den Verdampfer (2) vollständig. Das zu kühlende elektronische Bauteil (7), in diesem Falle eine CPU, ist auf einem CPU-Sockel (12) befestigt. Wie man sieht, ist die Verdampferhaube (3) in dem Fall an das spezifische Design des Sockels (12) angepasst. Diese wiederum befindet sich auf der Platine (15). Eine handelsübliche Andruckklammer (13), welche am CPU-Sockel (12) eingehakt ist, drückt die Verdampfereinheit (1) gegen das elektronische Bauteil (7). Damit die Rippen der Verdampferhaube (3) nicht übermäßig mechanisch belastet werden, befindet sich auf der Oberseite der Verdampferhaube (3) eine Andruckfläche (14), auf der die Andruckklammer (13) aufliegt. Die Montage der erfindungsgemäßen Kühlvorrichtung, speziell der Verdampfereinheit (1) an den zu kühlenden elektronische Bauteilen (7) erfordert somit keine große Umstellung für den Anwender, da er in diesem Fall auf handelsübliche Andruckklammern (13), die in der Regel bereits im Computer vorhanden sind, zurückgreift.

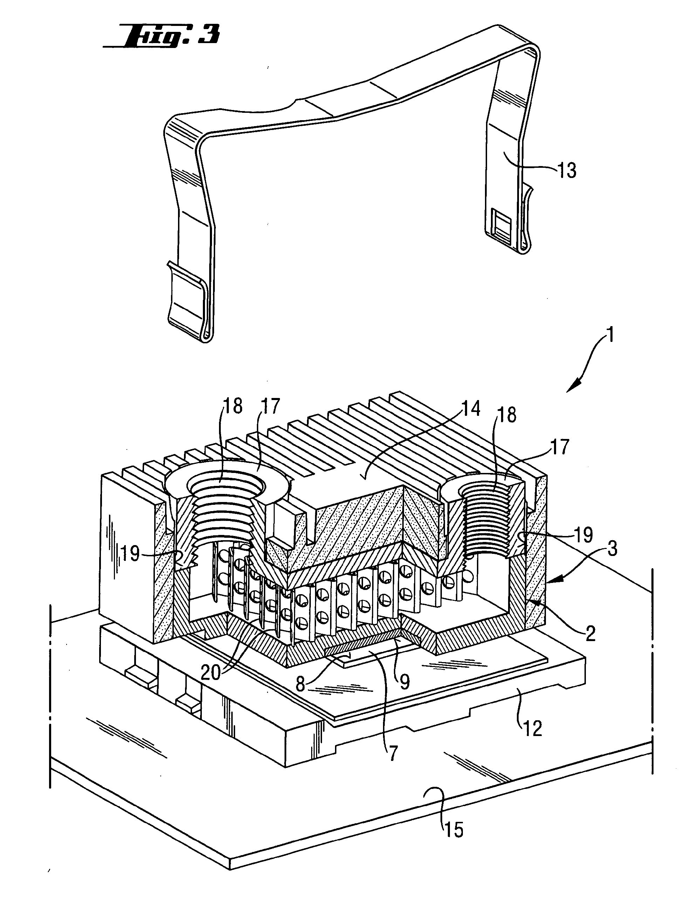

In Figur 3 sieht man einen Schnitt durch eine Verdampfereinheit (1). Dabei erkennt man die, den Verdampfer (2) umhüllende, Verdampferhaube (3) mit der Andruckfläche (14). Der abgebildete Verdampfer (2) hat eine Durchflusskammer (16) für das Kühlmedium (6) und Gewindestutzen (17) mit Innengewinde (18) für die Anschlussstutzen (11). Auf das Innengewinde kann auch verzichtet werden, wenn die Anschlussstutzen (11) direkt mit dem Verdampfer (2) verbunden sind, zum Beispiel durch eine Lötverbindung. Gleiches gilt auch für die Anschlussstutzen (11) am Dampfkondensator (4).
Die Durchflusskammer (16) ist im Beispiel von Fig. 3 mit vertikal angeordneten Lochblechen (20) versehen, welche für verbesserte Kühlung des elektronischen Bauteils (7) durch eine vergrößerte Wärmetauschfläche sorgen. Dieser Effekt lässt sich auch erzielen, indem man die Durchflusskammer (16) beispielsweise mit Metallwolle, wärmeleitfähigen Schäumen, Pulvern oder Fasern, Netzen, lamellenförmigen Folien oder Blechen oder mäanderförmigen Röhrensystemen ausstattet.

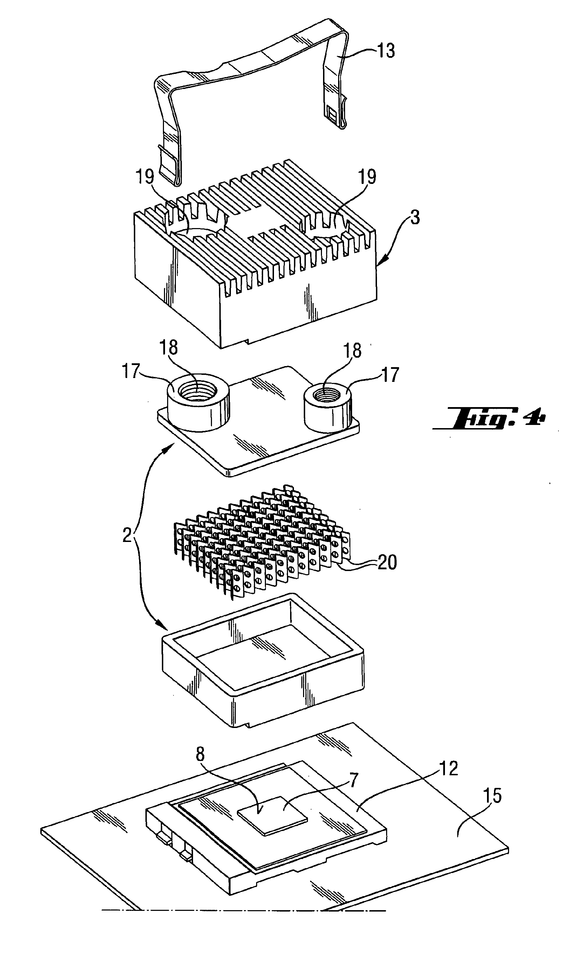

Figur 4 ist eine perspektivische Ansicht einer Verdampfereinheit (1). Man erkennt deutlich die Andruckfläche (14) sowie Bohrungen (19) mit einem Durchmesser, der etwas größer ist als der Außendurchmesser der Gewindestutzen (17).

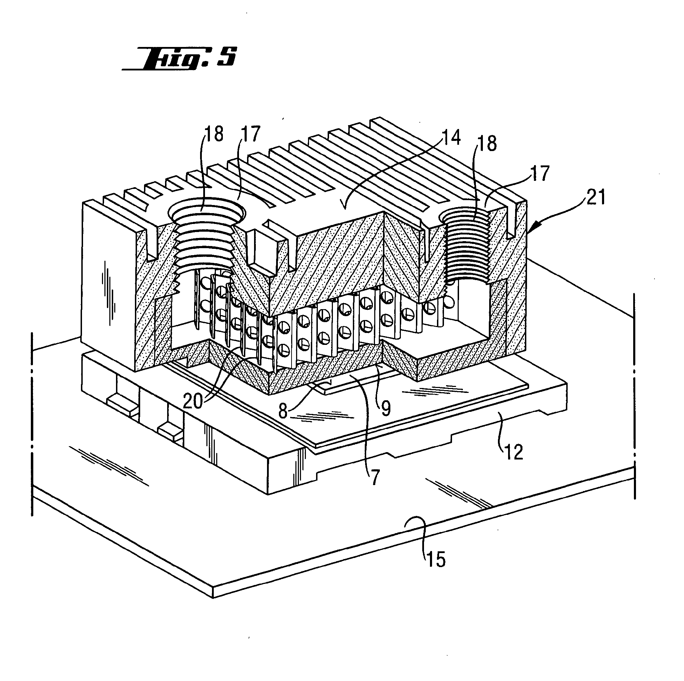

In Figur 5 wird eine perspektivische Schnittdarstellung einer Verdampfereinheit (21) gezeigt, welche vollständig aus graphithaltigem Material hergestellt ist. Erfindungsgemäße Kühlvorrichtungen wurden erfolgreich zum Kühlen von Computerbauelementen sowie von Hochlastschaltkreisen für Windgeneratoren und Schweißmaschinen getestet. Der geforderte LAT-Wert in den Computergehäusen von maximal 50 °C wurde unabhängig vom Typ und Anzahl der gekühlten Computerbauelemente erreicht.

## Patentansprüche

1. Kühlvorrichtung für elektronische und elektrische Bauelemente, **dadurch gekennzeichnet, dass** sie aus einem, von einem Kühlmedium (6) durchströmten, geschlossenen Kühlkreislauf mit einer Verdampfereinheit (1), fluidischen Verbindungen (5) und einem Dampfkondensator (4) ohne bewegliche mechanische Komponenten besteht.

2. Kühlvorrichtung nach Anspruch 1, **dadurch gekennzeichnet, dass** der Dampfkondensator (4) räumlich getrennt von der Verdampfereinheit (1) installiert ist, wobei der Auslauf des Dampfkondensators (4) höher liegt als der Einlauf der Verdampfereinheit (1).

3. Kühlvorrichtung nach Anspruch 1, **dadurch gekennzeichnet, dass** die vom Kühlmedium (6) auf dem Weg vom Verdampfer (2) zum Dampfkondensator (4) durchströmte Vorlaufverbindung (5a) einen zwei bis fünf mal größeren Innendurchmesser besitzt, als die Rücklaufverbindung (5b), in der das Kühlmedium (6) vom Dampfkondensator (4) zum Verdampfer (2) zurückfließt.

4. Verdampfereinheit (1) nach Anspruch 1, **dadurch gekennzeichnet, dass** sie aus einem Verdampfer (2) und einer umhüllenden Verdampferhaube (3) aufgebaut ist, welche flächig miteinander verklebt sind.

5. Verdampfer (2) nach Anspruch 4, **dadurch gekennzeichnet, dass** er aus einem Material mit einer Wärmeleitfähigkeit von mindestens 100 W/mK bei 20 °C besteht, eine vom Kühlmedium (6) durchströmte Durchflusskammer (16) besitzt und zwei Gewindestutzen (17) für Anschlussstutzen (11) aufweist.

6. Verdampfer (2) nach Anspruch 5, **dadurch gekennzeichnet, dass** er bevorzugt aus einem Metall wie Kupfer oder Aluminium besteht.

7. Verdampfer (2) nach Anspruch 5, **dadurch gekennzeichnet, dass** er aus thermoplastischen oder duroplastischen Kunststoffmischungen mit einem Füller von mehr als 50 Gew% Graphitpulver oder Kokspulver oder Mischungen daraus besteht, wobei dem Füller oder dem Kunststoff Ruß, Carbonfasern, Carbon Nanotubes und/oder Metall- und Keramikpartikel zugesetzt sein können.

8. Verdampfer (2) nach Anspruch 5, **dadurch gekennzeichnet, dass** die vom Kühlmedium (6) durchströmte Durchflusskammer (16) mit die Oberfläche vergrößernden Elemente wie Lochblechen (20), Metallwolle, wärmeleitfähigen Schäumen, Pulvern oder Fasern, Netzen, lamellenförmigen Folien oder Blechen oder mäanderförmigen Röhrensystemen ausstattet ist.

9. Verdampferhaube (3) nach Anspruch 4, **dadurch gekennzeichnet, dass** sie aus Graphitmaterial besteht sowie zwei Bohrungen (19) mit einem Durchmesser, der größer ist als der Außendurchmesser der Gewindestutzen (17), aufweist.

10. Verdampferhaube (3) nach Anspruch 9, **dadurch gekennzeichnet, dass** sie Rippen aufweist sowie eine Andruckfläche (14) für Andruckklammern (13) ausgebildet ist.

11. Verdampferhaube (3) nach Ansprüchen 9 oder 10, **dadurch gekennzeichnet, dass** sie aus synthetischem Graphit, Naturgraphit, Flockengraphit oder Mischungen daraus besteht, wobei dem Graphit oder den Mischungen Ruß, Carbonfasern, Carbon Nanotubes und/oder Metall- und Keramikpartikel zugesetzt werden können und das Graphit oder die Mischungen mit Metallen imprägniert sein können.

12. Verdampferhaube (3) nach Ansprüchen 9 oder 10, **dadurch gekennzeichnet, dass** sie aus thermoplastischem oder duroplastischem Kunststoffmischungen mit einem Füller von mehr als 50 Gew% Graphitpulver oder Kokspulver oder Mischungen daraus besteht, wobei dem Füller oder dem Kunststoff Ruß, Carbonfasern, Carbon Nanotubes und/oder Metall- und Keramikpartikel zugesetzt werden können und der Füller mit Metallen imprägniert sein kann.

13. Dampfkondensator (4) nach Anspruch 1, **dadurch gekennzeichnet, dass** er spezielle Einbauten, wie Wärmeleitbleche oder Netze, für eine Optimierung des Kreislaufprozesses enthält.

14. Dampfkondensator (4) nach Anspruch 1, **dadurch gekennzeichnet, dass** er einoder mehrstufig aufgebaut ist.

15. Dampfkondensator (4) nach Anspruch 14, **dadurch gekennzeichnet, dass** er aus einem oder mehreren nacheinander vom Kühlmedium (6) durchströmten Hohlzylindern, die thermisch weitestgehend voneinander entkoppelt, jedoch fluidisch miteinander verbunden sind, besteht.

16. Fluidische Verbindungen (5) nach Anspruch 1, **dadurch gekennzeichnet, dass** sie aus handelsüblichen Kühlmittelschläuchen oder ―rohren mit einer Druckdichte von über 30 bar und einem maximalen Außendurchmesser von 40 mm bestehen, welche chemisch und physikalisch gegenüber dem Kühlmedium (6) beständig und druck- und vakuumdicht sind, und über Anschlussstutzen (11) am Verdampfer (2) und Dampfkondensator (4) durch Bajonettverschlüsse oder ähnliche konstruktive Vorkehrungen gegen eine Lockerung abgesichert sind.

17. Kühlmedium (6) nach Anspruch 1, **dadurch gekennzeichnet, dass** es aus einer chemischen Substanz mit einem Siedepunkt zwischen -60 °C bis 0 °C, wie etwa Propan, Butan sowie die Kühlmittel R152a, R134a, R22 oder deren Äquivalente, oder einem Gemisch solcher Substanzen besteht.

18. Kühlvorrichtung nach Anspruch 1, **dadurch gekennzeichnet, dass** mehrere Verdampfereinheiten (1) zur Kühlung von mehreren elektronischen Bauteilen (7) vorgesehen sind, wobei die mehreren Verdampfereinheiten (1) mit einem oder mehreren Dampfkondensatoren (4) fluidisch verbunden sind.
